# EUROPEAN PATENT SPECIFICATION

(11) **EP 4 446 281 B1**
(45) Date of publication and mention of the grant of the patent: **11.11.2026**
(21) Application number: 23167967.1
(22) Date of filing: 14.04.2023
(51) Int. Cl.: B81B 7/00

(54) **DOUBLE LAYER MEMS DEVICES AND METHOD OF MANUFACTURE**
DOPPELSCHICHTIGE MEMS-VORRICHTUNGEN UND HERSTELLUNGSVERFAHREN
DISPOSITIFS MEMS À DOUBLE COUCHE ET PROCÉDÉ DE FABRICATION

(43) Date of publication of application: 16.10.2024
(73) Proprietor: Murata Manufacturing Co., Ltd., Nagaokakyo-shi, Kyoto 617-8555 (JP)
(72) Inventor: KILPINEN, Petteri, 02620 Espoo (FI); PEUSSA, Marko, 02210 Espoo (FI); IIHOLA, Antti, 00950 Helsinki (FI); TORKKELI, Altti, 04340 Tuusula (FI)
(74) Representative: Boco IP Oy Ab

(56) References cited:
- US-A1- 2015 232 327
- US-B2- 7 317 233
- US-B2- 9 463 976

## Description

### Field

The present invention relates to MEMS devices and a method of producing MEMS devices. More particularly, the present invention relates to MEMS devices comprising two device layers and to method for manufacturing double layer MEMS devices.

### Background

Microelectromechanical systems (MEMS) devices manufactured using silicon-based technology are widespread. Typical application of MEMS device is an inertial sensor that detects at least one of acceleration and angular velocity. MEMS devices of this type are widely used in consumer, automotive and industrial applications.

Capacitive sensing in MEMS devices is implemented by detecting change of capacitance caused by change in distance between two electrodes. Typically, capacitance is sensed between a moveable electrode and one or more static electrodes.

In typical capacitive MEMS devices for inertial sensing, static electrodes are provided on a substrate, such as a handle or a cap wafer. For example, a metal electrode may be provided on a surface of the substrate wafer. The MEMS device is subject to various sources of stress. During packaging of components, some steps of the manufacturing method such as molding applies pressure on the substrate. Different materials have different thermal characteristics and therefore the substrate may also be subject to pressure due to differences in thermal expansion of materials within the MEMS device package. The MEMS device may also be subject to various external forces causing changes in the shape of the substrate. Environment in which the MEMS device is used may be subject to great temperature changes, vibration, impacts and so on, all causing stress on the MEMS device. When static electrodes are attached to the substrate, any change in form of the substrate caused by stress may also affect distance between the static electrodes and respective moveable electrodes. This causes risk of deterioration of accuracy of capacitive sensing.

In the following description, reference will be made to an inertial MEMS sensor and to the problems for the manufacturing thereof. However, the present disclosure generally applies to other types of MEMS devices. For example, the MEMS device may comprise one or more of the following structures, single or combined with each other: accelerometer, gyroscope, geophone, inclinometer and resonator. Furthermore, the MEMS device may be a MEMS actuator.

### Description of the related art

Patent US10830590 discloses a micromechanical sensor with a substrate including a mechanical functional layer made of monocrystalline silicon and an electrode device. An electrically conductive wiring layer with aluminium or tungsten wiring.

Patent application US20200156930 discloses a double side capacitive sensing MEMS device having a hollow body. This device is manufactured by epitaxial growing of a polysilicon (poly-Si) structure.

Patent US9463976 discloses a vertically stacked MEMS device wafer assembly to generate an integrated MEMS device having vertically stacked inertial transducer elements each in different layer of the multilayer semiconductor structure. Different MEMS transducer structures are hermetically barred from ambient environment and from each other.

US2015/232327 A1 discloses a sensor having a decoupling structure. The sensor includes a substrate, a microelectromechanical structure and a decoupling structure anchored on the substrate. The microelectromechanical structure is anchored on the decoupling structure. The decoupling structure is situated between the microelectromechanical structure and the substrate. A cap structure of a cap wafer is provided.

### Summary

An object is to provide a method and apparatus so as to solve the problem of decreasing material costs of the MEMS device while improving robustness of the MEMS device with wider gap and smaller signal paths between device layers. The objects of the present invention are achieved with a MEMS device according to the claim 1. The objects of the present invention are further achieved with a manufacturing method according to the claim 6.

The preferred embodiments of the invention are disclosed in the dependent claims.

According to a first aspect of the invention, a microelectromechanical system (MEMS) device is provided. The MEMS device comprises, in order from bottom to top: i) a handle layer comprising at least one cavity and at least one suspension structure, ii) a first electrically insulating layer, iii) a first device layer formed by patterning a layer of deposited polycrystalline silicon (poly-Si), wherein at least one structural element in the first device layer is suspended by the at least one suspension structure, and the at least one structural element optionally comprises at least one seismic element, iv) a second electrically insulating layer, v) a second device layer comprising at least one seismic element moveably suspended above the first device layer, wherein the second device layer is formed by patterning a layer of single-crystal silicon (mono-Si), and vi) a cap layer.

The handle layer, the first device layer, the second device layer and the cap layer, the first electrically insulating layer bonding the handle layer and the first device layer and the second electrically insulating layer bonding the first device layer and the second device layer are configured to form walls of an enclosure comprising the at least one seismic element and at least one static electrode and at least one moveable electrode for detecting and/or causing motion of the at least one seismic element. The at least one static electrode is in the first device layer.

According to an embodiment of the invention, the second electrically insulating layer is provided with at least one polycrystalline silicon (poly-Si) feedthrough extending from the first device layer through the second electrically insulating layer to the second device layer for electrically coupling a structural element of the first device layer to a structural element of the second device layer and/or to an electrical connection provided in the cap layer.

According to an embodiment of the invention, electrically insulating material in the second electrically insulating layer has been removed about the at least one poly-Si feedthrough such that the at least one poly-Si feedthrough is the only mechanical contact between the respective structural elements of the first device layer and the second device layer.

According to an embodiment of the invention, the first device layer comprises at least one stopper structure extending towards the second device layer over a distance that is less than thickness of the second electrically insulating layer.

According to an embodiment of the invention, the MEMS device further comprises a metallic bonding layer between the second device layer and the cap layer, and the metallic bonding layer is further configured to form part of said walls of the enclosure.

According to a second aspect of the invention, a method for manufacturing a MEMS device is provided. The manufacturing method comprises steps i) forming the handle layer out of a mono-Si handle wafer, the forming of the handle layer comprising forming at least one cavity and simultaneously forming the at least one suspension structure on a first face of the handle layer, and covering the first face of the handle layer with a first electrically insulating layer, ii) forming a second electrically insulating layer on a mono-Si wafer; iii) patterning the second electrically insulating layer; iv) depositing a poly-Si layer on top of the patterned second electrically insulating layer; v) forming the first device layer out of the first poly-Si layer, the forming the first device layer comprising thinning the first poly-Si layer into a first thickness and forming a plurality of first trenches extending through the first device layer by means of dry etching; vi) fusion bonding the first device layer on the first electrically insulating layer on the first face of the handle layer; vii) forming the second device layer out of the mono-Si wafer, the forming the second layer comprising thinning the mono-Si wafer into a second thickness, optionally forming at least one recessed area in the second mono-Si wafer, and dry etching a plurality of second trenches extending through the second mono-Si wafer; viii) releasing structural elements of the first and second device layer by removing exposed portions of the first and second electrically insulating layers over thickness of the first and second electrically insulating layers by hydrofluoric acid (HF) etching; and ix) enclosing structural elements within the enclosure by bonding the cap layer on top of the second device layer.

According to an embodiment of the invention, the step of patterning the second electrically insulating layer comprises removing one or more portions of the second electrically insulating layer over the entire thickness of the second electrically insulating layer, and the step of depositing a poly-Si layer causes, by filling said removed portions of the second electrically insulating layer with deposited poly-Si, generation of one or more poly-Si feedthroughs extending from the first device layer through the second electrically insulating layer to the second device layer for electrically coupling one or more structural elements of the first device layer and the second device layer.

According to an embodiment of the invention, the step of patterning the second electrically insulating layer comprises recessing one or more portions of the second electrically insulating layer over a part of thickness of the second electrically insulating layer, and the step of depositing a poly-Si layer further causes, by filling said recessed one or more portions of the second electrically insulating layer, generating one or more poly-Si stopper structures extending towards the second device layer.

According to an embodiment of the invention, the method further comprises forming at least one recessed area in the mono-Si wafer after thinning the first poly-Si layer into a first thickness and before forming a plurality of first trenches extending through the first device layer.

According to an embodiment of the invention, the method further comprises bonding the second device layer with the cap layer by a metallic bonding layer.

The present invention is based on the idea of having two suspended device layers in the MEMS device. In this context, we refer to elements having a role in functionality of the MEMS device as structural elements. These structural elements may be fixed, such as support structures, electrical connections and static electrodes. Structural elements in the first device layer are suspended to a handle layer and/or via the second device layer to a cap layer by rigid suspension structures, such as anchors. The first device layer comprises structural elements used as static electrodes and the first device layer may also be used for electrical routing. Both device layers may comprise seismic masses used as moveable electrodes and/or seismic masses coupled to moveable electrodes. The second device layer may also comprise static electrodes. As known in the art, suspension of seismic masses typically comprises flexible suspension structures such as springs and beams that are designed to enable one or more wanted movement directions of the seismic mass but to suppress any unwanted movement directions of the seismic mass. One of the device layers is made of monocrystalline silicon (mono-Si), and the other device layer is made of polycrystalline silicon (poly-Si). Patterns on the device layers may be manufactured using a silicon-on-insulator, SOI, process that utilizes etching, preferably dry etching such as deep reactive-ion etching (DRIE) or like, for determining structural elements in the device layers.

The present invention has the advantage that the two device-layer structure improves accuracy of the MEMS device by providing mechanically stable structures within the MEMS device that are robust against stress deformation, while the invented device structure also facilitates high design flexibility and small die area. Because both moving and static electrodes can be implemented as mechanically separated from the substrate (the handle layer and the cap layer), stress affecting the substrate does not cause changes in geometry of the structural elements in the device layers. Sensitivity to stress can further be improved by suspending both device layers on laterally common anchor locations. According to some embodiments, the double silicon device layered design can be designed and manufactured without need for perforation of seismic elements and/or other structural elements in the device layers, thus avoiding reduction of capacitance and mass caused by such perforation, which facilitates higher capacitances and thereby improved sensitivity of the MEMS device. Although poly-Si device layer may be considered inferior in some technical characteristics when compared to a mono-Si device layer, the poly-Si device layer is in most cases cheaper to manufacture, depending on thickness of the poly-Si layer. Thus, the MEMS device according to embodiments of the invention is more cost efficient than a MEMS device comprising two mono-Si device layers. Furthermore, characteristics of two different silicon layers enable improved design freedom in comparison to use of mono-Si device layers only.

### Brief description of the drawings

In the following the invention will be described in greater detail, in connection with preferred embodiments, with reference to the attached drawings, in which
Figure 1 illustrates a cross-section of a MEMS device according to a first embodiment
Figure 2 illustrates a cross-section of a MEMS device according to a second embodiment
Figure 3 illustrates a cross-section of a MEMS device according to a third embodiment
Figure 4 illustrates a cross-section of a MEMS device according to a fourth embodiment
Figures 5a to 5j illustrate a manufacturing method of a MEMS device
Figures 6a to 6c illustrate generation of a stopper structure in the manufacturing method

### Detailed description

Single-crystal silicon, mono-Si, known also as monocrystalline silicon is the well-known base semiconductor material for silicon-based discrete components and integrated circuits. It consists of silicon in which the crystal lattice of the entire solid is continuous. Mono-Si is the material of first choice for robust MEMS devices, because of its excellent mechanical strength and elasticity, and the large variety of available standard processes. It is well known in the art, that in MEMS devices, mono-Si layer is used as a conductor, for which purpose it is doped to make it electrically conducting. For example, Boron-doped P-type silicon wafers are common, but also Phosphorus (P) doped N-type wafers are used in some special applications.

In this context, polysilicon, poly-Si, known also as polycrystalline silicon or multicrystalline silicon refers to silicon consisting of small crystals, known as crystallites. Like mono-Si, also polysilicon is doped to make it electrically conducting. Poly-Si comprises mutually differently aligned crystals. Therefore, its elasticity constant is not dependent on geometry and/or direction as is the case with mono-Si. Poly-Si does not comprise oxygen like Czochralski process (CZ) grown mono-Si crystal. Furthermore, characteristics of poly-Si are easier to adjust. For example, it is easier to adjust conductivity thereof by doping, and especially highly doped poly-Si is easier to achieve than mono-Si.

In this context, silicon dioxide, known also as silica, is an oxide of silicon with chemical formula SiO₂. Silicon dioxide is an electrical insulator.

In the following description, direction up refers to direction of the positive z-axis and direction down is direction of negative z-axis for convenience. It is to be understood, that these directions are not to be understood as limiting the position of use of the MEMS device. The simplified MEMS device has only a limited number of structural elements, such as anchors, beams, electrical contacts, masses and/or limiters, often just one of each. It is understood by a skilled person that an actual MEMS device may comprise more than one of any of such structural elements in any combination.

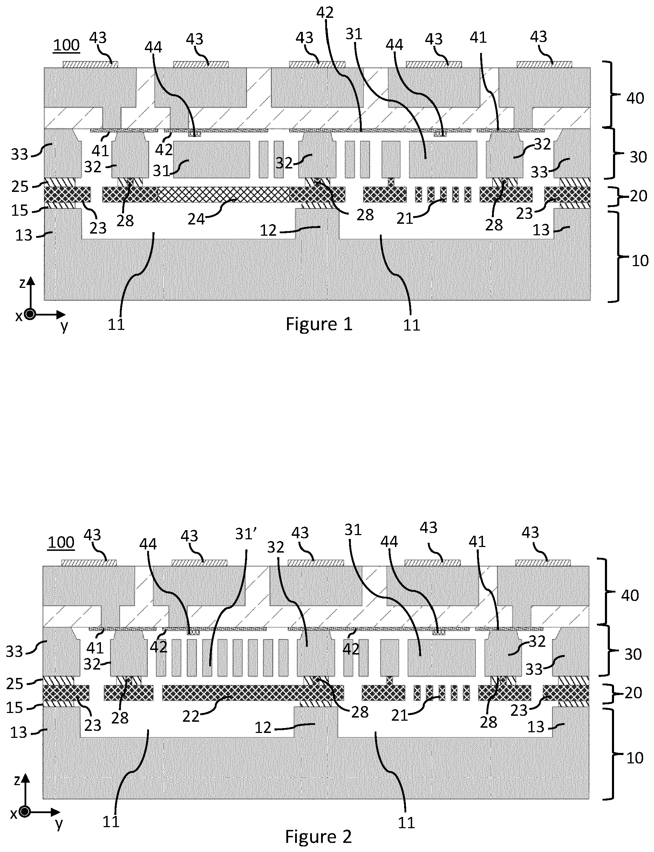

Figure 1 illustrates a cross-section of a MEMS device according to a first embodiment. Drawing is not in scale.

Starting from the bottom of the MEMS device **100,** first layer is a handle layer **10** made of mono-Si. The handle layer **10** comprises at least one cavity 11. In the cavity **11,** there is at least one suspension structure **12** also known as anchor. The at least one cavity **11** is preferably formed as a basin such that it does not reach lateral sides of the handle layer **10,** so that walls **13** are provided in the handle layer **10** at least on the outer circumference thereof. The at least one cavity **11** increases distance from the bottom of the cavity **11** towards a first device layer **20** above the handle layer **10.** This increased distance reduces risk of mechanical contact of a seismic element in the first device layer **20** with the handle layer **10** and decreases unwanted parasitic capacitance between the handle layer **10** and structural elements in the superimposed first device layer 20.

Between the handle layer **10** and the first device layer **20,** there is an electrically insulating layer 15. Majority of the sacrificial electrically insulating layer **15** is removed during the manufacturing process, but as can be seen in the Figure 1, portions of the electrically insulating layer **15** remain between the handle layer **10** and the first device layer 20. The electrically insulating layer is preferably made of silicon dioxide. The electrically insulating layer **15** facilitates bonding between the handle layer **10** and the first device layer **20,** forms a part of walls of an enclosure in which all structural elements of the MEMS device are enclosed and is also used as sacrificial layer during manufacture, while supporting and protecting structures during the manufacturing process before removed.

The first device layer **20** made of poly-Si comprises structural elements that are mechanically suspended on the suspension structures **12** provided in the handle layer **10** and/or by suspension structures **32** provided in a second device layer **30** conveying suspension on the cap layer **40.** Structural elements on the first device layer **20** may be fixed or seismic. Seismic structural elements refer to elements which are configured to move in response to a physical phenomenon, such as pressure, acceleration or angular velocity. Thickness of the poly-Si layer can be designed on basis of requirements set by types of structural elements in it. Structural elements on the first device layer **10** are advantageously used for example as fixed or seismic elements **21,** such as electrodes in capacitive electrode pairs that may be used either for sensing or for driving purposes. Another possible use of structural elements on the first device layer **10** is for signal routing. This is illustrated by signal bearing beam **24** that may travel between a seismic element **31** on the second device layer **30** and the cavity **11.** For reducing unwanted capacitance between the seismic element **31** and the signal bearing beam **24,** the signal bearing beam **24** is preferably made narrow in lateral (x-axis) dimension so that overlapping area between the two is small.

The first device layer **20** preferably comprises a frame portion **23** that encircles structural elements of the first device layer **20** and forms part of outer walls of the enclosure that comprises structural elements of the MEMS device.

Because structural elements on the first device layer **20** are only supported to the handle layer **10** and/or via the second device layer **30** to the cap layer **40** by distinct suspension structures **12, 32,** structural elements on the first device layer **20** are less sensitive to stress affecting the MEMS device **100:** deformation of the cap layer **40** or the handle layer **10** due to stress causes less deformation or displacement of structural elements on the first device layer **20** and thus less change in distance occurs between structural elements of the first device layer to structural elements of the second device layer **30** due to mechanical stress affecting the MEMS device **100.**

Above the first device layer **20,** there is a second device layer **30** that comprises seismic elements **31** of the MEMS device **100.** For facilitating seismic movement, mass of seismic elements **31** can be increased by making the second device layer **30** thicker than the first device layer **20.**

Between the first device layer **20** and the second device layer **30,** there is an electrically insulating layer **25.** Majority of the electrically insulating layer **25** is removed in the manufacturing process, but as can be seen in the Figure 1, portions of the electrically insulating layer **25** remain between the first device layer **20** and the second device layer **30.** The electrically insulating layer is preferably made of silicon dioxide. The electrically insulating layer **25** facilitates bonding between the first device layer **20** and the second device layer **30,** forms a part of walls of an enclosure in which all structural elements of the MEMS device are enclosed and is also used as sacrificial layer during manufacture, while supporting and protecting structures during the manufacturing process before removed.

Poly-Si feedthroughs **28** extending from the first device layer **20** provide electrical connections over the electrically insulating layer **25** between the first device layer **20** and the second device layer **30,** enabling carrying electrical signals to and from the first device layer **20.**

The second device layer **30** is made of mono-Si and comprises seismic elements that are indirectly, via the first device layer **20,** suspended on the suspension structures **12** provided in the handle layer **10** and/or by rigid suspension structures **32** within the second device layer **30** that are suspended on the cap layer **40.** As known in the art, for enabling movement of the seismic elements **31,** suspension thereof is implemented with springs and/or flexible beams (not shown).

The second device layer **30** preferably comprises a frame portion **33** that encircles structural elements of the second device layer **30** and forms part of outer walls of the enclosure that comprises structural elements of the MEMS device **100.**

Structural parts of the first and second device layers **20, 30** are enclosed in an enclosure between the handle wafer **10** and a cap layer **40** that is bonded on top of the second device layer 30. Walls **13** of the handle wafer **10,** frame portions **23, 33** of the first and second device layers **20, 30** together with insulator layers **15, 25** form walls of the enclosure.

In the shown example, the cap layer **40** comprises metallized contacts **41** on the bottom face of the cap layer **40** that both mechanically and electrically couple the support structures 32. Optionally, metallized patterns may also be provided on the bottom face of the cap layer **40** to operate as static electrodes 42. Metallized contacts **41** and static electrodes **42** are electrically coupled through the cap layer **40** to metallized contact pads **43** on the top side of the cap layer 40. When no electrical contact is required between a support structure **32** and the cap layer **40,** support structures **32** may be mechanically bonded to the cap layer **40** by anodic bonding. For maximum stress robustness, only the first device layer **10** should be used for static electrodes **21,** but not the cap layer 40. Implementing further static electrodes **42** on the cap layer **40** makes the MEMS device more susceptible to the stress.

Optionally, the cap layer **40** may be provided with one or more bumps **44** that prevent the one or more seismic masses **31** from becoming into direct contact with the static electrodes **42** or other metallized patterns on the bottom face of the cap layer 40. Bumps **44** are preferably made of electrically insulating material such as SiO₂ or Si₄N₄.

Figure 2 illustrates a cross-section of a MEMS device according to a second embodiment. Drawing is not in scale.

Device layers in the second embodiment correspond to the first embodiment. The main difference is that a structural element **22** such as an electrode or another seismic mass is provided in the first device layer **20** below the seismic mass **31'** for capacitive detection of movement of the seismic mass 31'. In this case, lateral area of the structural element **22** may need to be so big, that a manufacturing method step for removing sacrificial silicon oxide by etching would not fully remove the sacrificial insulator layer **15** between the seismic mass **31'** and the structural element 22. By perforating the seismic mass **31',** efficient removal of the sacrificial layer is facilitated with the cost of reduced mass of the seismic mass 31'. However, this may be acceptable, depending on the MEMS device design.

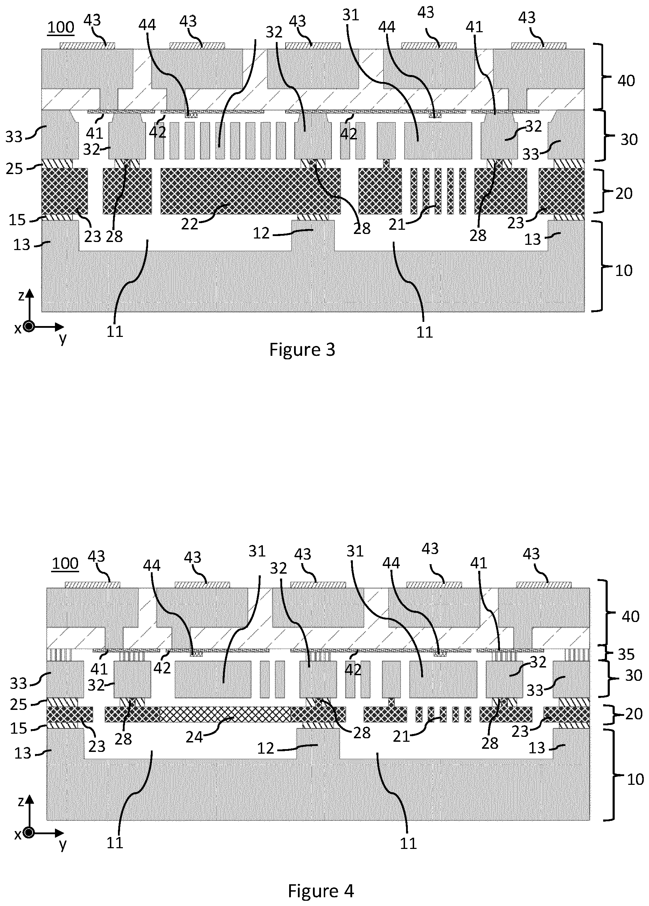

Figure 3 illustrates a cross-section of a MEMS device according to a third embodiment. Drawing is not in scale.

The bottom layer **10,** and the second device layer **30** are similar to the second embodiment. Both layout and thickness of the second layer may be designed to achieve desired mass of structural elements **21, 22** in the first device layer 20. Increased mass is particularly beneficial with seismic elements. As understood by a skilled person, any one of the designs described herein, including the first and third embodiment, may have structural elements, in particular seismic elements in the first device layer **20** that benefit from having more mass by increasing thickness of the first device layer **20.**

Figure 4 illustrates a cross-section of a MEMS device according to a fourth embodiment. Drawing is not in scale.

In the figure 4, the bottom layer **10,** the first device layer **20** and the second device layer **30** are according to the second embodiment but this embodiment is equally applicable with the first and third embodiment. Main difference from any of the above described embodiments is that there is an additional metal bonding layer **35** between the second device layer **30** and the cap layer **40.** Consequently, the second device layer does not require recessing on the side of the cap layer **40** during the manufacturing process, since the metal bonding layer **35** introduces additional distance between the second device layer **30,** in particular, seismic masses **31** therein, and the cap layer **40.** The concept of recessing is further explained below in connection with the exemplary manufacturing method.

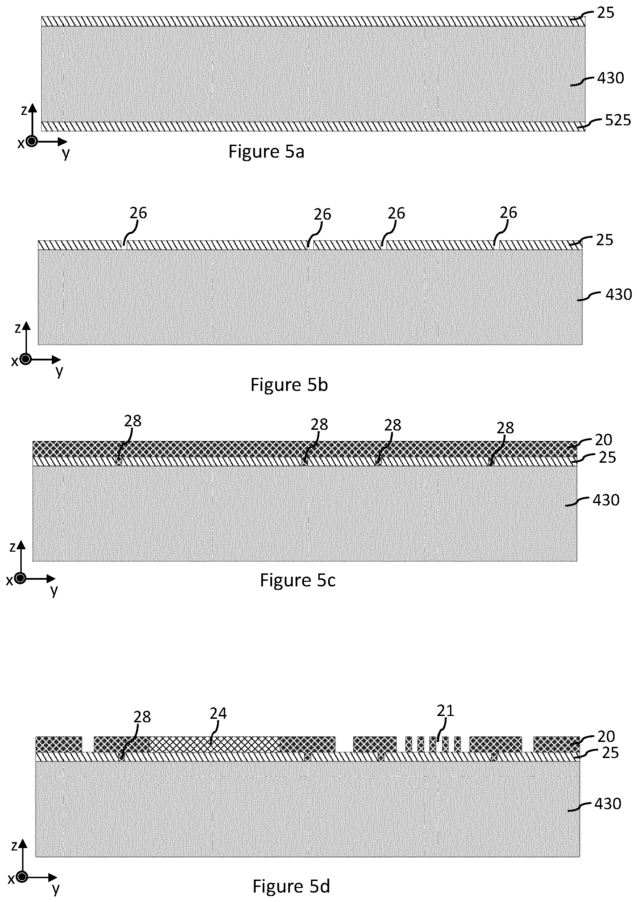

Figures 5a to 5j illustrate an exemplary manufacturing method of a MEMS device according to the first embodiment. Although this process is illustrated in connection with the first embodiment, it can be easily adjusted, if needed, to enable manufacturing of devices according to the other embodiments.

Figure 5a shows a device wafer **430,** which will be eventually become the second device layer. The device wafer **430** is a mono-Si wafer. An electrically insulating layer **25,** preferably of silicon dioxide is built on one face of the device wafer **430.** Optionally, the other face of the device wafer **430** is also protected initially with an electrically insulating layer **525.** Electrically insulating layers **25, 525** are typically generated on surfaces of a wafer using thermal oxidation, which typically generates an oxide layer (a silicon dioxide layer) on all faces of the device wafer **430.**

Figure 5b shows patterning of the electrically insulating layer **25.** The electrically insulating layer **25** is patterned by etching. Examples of applicable etching methods are wet etching by buffered hydrofluoric acid (BHF) and reactive ion plasma etching. In this example, etching is used for removing portions **26** of the electrically insulating layer **25** for purpose of generating poly-Si feedthroughs further in the process, for electrically connecting the second device layer and the first device layer.

When using wet etching, the electrically insulating layer **525** is preferably removed from the backside of the first device wafer **430,** because remaining the electrically insulating layer **525** would require additional back side protection with photoresist. Net stress of the poly-Si layer needs to be small and, in some cases, preferentially tensile. As thermally grown silicon dioxide has compressive stress, removal of electrically insulating layer **525** results in such cases smaller net stress on the wafer's top side, which helps to minimize wafer bow to ease wafer handling during processing.

Figure 5c illustrates next step, in which a first device layer **20** is deposited on top of the patterned electrically insulating layer 25. The first device layer **20** is a poly-Si layer. Poly-Si plugs **28** for electrically connecting the first device layer and the second device layer are generated during this deposition step.

Typical steps of depositing a poly-Si layer comprises
1) depositing a thin in-situ doped poly-Si layer. This is typically performed by a low-pressure chemical vapor deposition (LPCVD) process
2) depositing a thick in-situ doped poly-Si layer. This is typically performed by an atmospheric pressure chemical vapor deposition (APCVD) using epitaxial silicon deposition tool, nicknamed as "epi-poly"
3) polishing the poly-Si layer using chemical mechanical polishing (CMP)

In some cases, grinding of the poly-Si layer may be needed before it can be polished by CMP.

LPCVD may be used to combine steps 1 and 2, but LPCVD has 100 to 1000 times lower deposition rate than APCVD, so depositing layers with thickness required for functional MEMS device layer is not practical. For example, thickness of the poly-Si layer deposited in the steps 1 and 2 may be in the order of 5 µm.

An alternative doping method is undoped deposition and doping the poly-Si layer by ion-implantation or diffusion from a solid source, such as a doped oxide, followed by annealing.

During LPCVD, deposition of poly-Si on the backside of the device wafer **430,** may occur. However, this can be disregarded, since the backside of the device wafer **430** will be grinded later in the process, which removes any unwanted deposition thereon.

Net stress of the poly-Si layer needs to be small.

Figure 5d illustrates patterning of the first device layer **20.** The first device layer is preferably patterned using lithography and etching, such as DRIE etching. During patterning, structural elements **21, 24** are formed in the first device layer **20** by a plurality of trenches extending through the first device layer **20** to the second electrically insulating layer **25.**

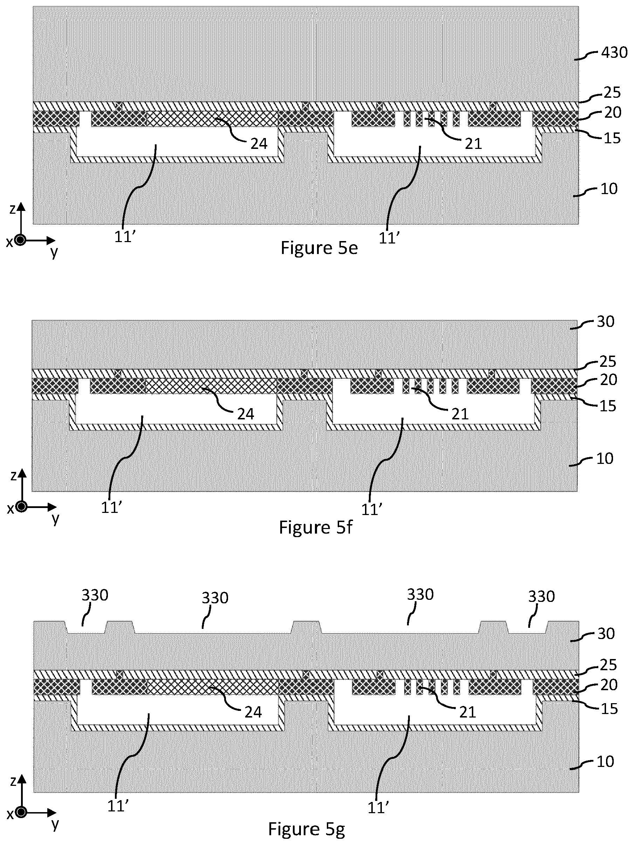

Figure 5e illustrates a phase after fusion bonding the first device layer **20** with the handle layer **10** that comprises at least one oxidized cavity **11'.** For this purpose, the work item has been flipped upside down so that the first device layer **20** is downwards and the second device wafer **430** is on the top.

Figure 5f illustrates a step after the second device wafer **430** has been thinned at least approximately into a thickness of the second device layer **30** for example by using grinding and/or etching. Chemical mechanical polishing (CMP) is used to provide smooth surface and to remove roughness after thinning and residual surface damages from grinding. A thick second device layer **30** facilitates heavier, thus more sensitive seismic masses.

Figure 5g illustrates recessed portions **330** on the upper face of the second device layer **30.** Recessing of the recessed portions **330** can be performed using a Local Oxidation of Silicon (LOCOS) process, where SiO₂ is formed in selected areas on the upper face of the second device layer **30** and subsequently the formed SiO₂ is removed by etching to form the recessed portions **330** on the surface. Other alternatives exist, such as etching. One purpose of this recession is to form free space above seismic masses such that they have room for movement in z-axis direction also after a cap layer has been placed on top. Alternative to LOCOS process, recess can be made using silicon wet etching or plasma etching. As was discussed above in reference to the fourth embodiment shown in the figure 4, generation of recesses portions **330** may be omitted, if metallic bonding is used for attaching a cap layer, because metallic bonding layer increases distance between seismic masses and the cap layer, which helps in avoiding mechanical contacts between these.

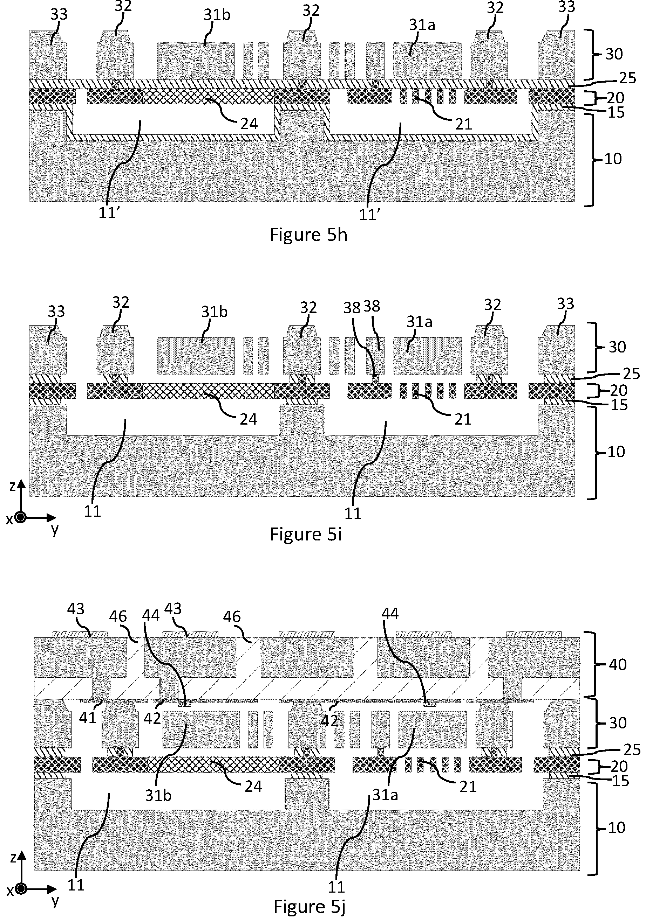

Figure 5h illustrates forming of structural elements such as support structures **32** and seismic masses **31a, 31b** in the second device layer **30** by patterning and etching the mono-Si layer of using dry etching such as DRIE. Structural elements of the second device layer are determined by a plurality of trenches extending through the first device layer **20** to the second electrically insulating layer 25. Although not shown, support structures in the second device layer also comprise springs and/or beams that control movement of the seismic masses. During DRIE etching, the portions of the second device layer **30** that are not to be etched are protected by a masking pattern of for example silicon dioxide (not shown).

Figure 5i illustrates results of releasing structural elements in the first **20** and second device layers **30** by removing buried SiO₂. This can be performed using hydrofluoric acid (HF) etching. In controlled HF release, a defined amount of SiO₂ is removed in all directions. The HF release also removes electrically insulating layer from the cavity **11** and a portion of the electrically insulating layer between the handle layer **10** and the first device layer **20** on the suspension structures **12** and on the side walls **13,** between support structures **32** and structural elements on the first device layer **20** and between frame portions **23, 33** of the first device layer **20** and the second device layer 10. Sufficient area of electrically insulating layer **15, 25** remains to maintain contact between the handle layer **10,** the first device layer **20** and the second device layer **30** where needed.

According to some embodiments, one or more support structures **32** may be designed to have smaller lateral dimensions such that electrically insulating layer is fully removed between the one or more support structures **32** and the first device layer 20. An example of a laterally small mechanical coupling **38** between the first device layer **20** and the second device layer **30** is shown in the figure 5i. Removal of the entire portion of electrically insulating layer **25** between a structural element of the first device layer **20** and a structural element of the second device layer **30** is enabled by designing at least one of the respective structural elements to have a small lateral area. In this nonlimiting example, the structural element **37** in the second device layer **30** has small lateral dimension so that during etching of the electrically insulating layer **25,** all electrically insulating material is removed at this location. This way, mechanical connections between any structural element in the second device layer **30** and structural element in the first device layer **20** may have distinctively small lateral area, which facilitates making the devices with multiple anchors smaller in size. This mechanical connection is based on poly-Si is also capable of providing an electrical connection between the two structural elements.

Figure 5j illustrates the MEMS device **100** after structural elements have been enclosed in an enclosure by fixing a cap layer **40** on top of the second device layer 30. In this example, the cap layer **40** comprises glass **46** insulated silicon and metallized contacts **41, 43,** optional static electrodes **42,** and the cap layer **40** is attached using anodic bonding and using anodic bonding and subsequent back-end process. Instead of the glass insulated silicon cap layer, any other suitable type of cap layer can be used in any of the disclosed embodiments. For example, the cap layer may be an Integrated Circuit (IC) wafer with electrodes.

According to some embodiments, the cap layer **40** may be bonded on top of the second device layer **30** using metallic bonding as illustrated in the figure 4. In such case, the recessing step illustrated in the figure 5g may be omitted such that in the step 5f, the first device layer **30** is simply thinned to its desired thickness before forming structural elements therein by patterning and etching.

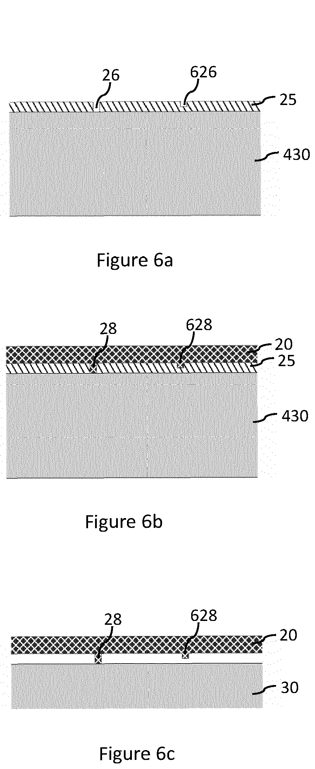

Figures 6a to 6c illustrate generation of a stopper structure often referred to as a "bump" extending out of the first device layer 20. Such stopper structure may be beneficial between the first device layer **20** and the second device layer **30** to avoid sticking of seismic element to a superimposed structure, such as an electrode or even another seismic element. Only a portion of different material layers and structures of the MEMS device are shown for simplicity.

Figure 6a illustrates patterning of the electrically insulating layer **25** as in the figure 5b. In addition to removing portions **26** so that the device wafer **430** becomes exposed for generating the feedthrough, one or more shallow recesses **626** are generated into the electrically insulating layer 25. These recesses **626** only extend over a portion of the thickness of the electrically insulating layer 25.

Figure 6b illustrates a first device layer **20** being deposited, simultaneously creating a feedthrough **28** and the stopper structure 628.

Figure 6c illustrates appearance of the exemplary feedthrough **28** and the stopper structure **628** after releasing structural elements as illustrated in the figure 5i. In this simplified illustration, neither the first device layer **20** nor the second device layer **30** are not shown as having any other structural elements, but as understood by a skilled person, this is the case as is shown in the figure 5i, and also the bottom layer **10** is already comprised in the work piece at this phase.

It is apparent to a person skilled in the art that as technology advanced, the basic idea of the invention can be implemented in various ways. The invention and its embodiments are therefore not restricted to the above examples, but they may vary within the scope of the claims.

## Claims

1. A microelectromechanical system (MEMS) device comprising, in order from bottom to top:
- a handle layer (10) comprising at least one cavity and at least one suspension structure (12),
- a first electrically insulating layer (15),
- a first device layer (20) formed by patterning a layer of deposited polycrystalline silicon, poly-Si, wherein at least one structural element in the first device layer is suspended by the at least one suspension structure (12), and the at least one structural element optionally comprises at least one seismic element (22),
- a second electrically insulating layer (25),
- a second device layer (30) comprising at least one seismic element (31) moveably suspended above the first device layer, wherein the second device layer is formed by patterning a layer of single-crystal silicon, mono-Si, and
- a cap layer (40),
wherein the handle layer (10), the first device layer (20), the second device layer (30) and the cap layer (40), the first electrically insulating layer (15) bonding the handle layer and the first device layer and the second electrically insulating layer (25) bonding the first device layer (20) and the second device (30) layer are configured to form walls of an enclosure comprising the at least one seismic element (31) in the second device layer (30), and at least one static electrode (21) and at least one moveable electrode for detecting and/or causing motion of the at least one seismic element (31), wherein the at least one static electrode (21) is in the first device layer (20).

2. The MEMS device according to claim 1, wherein the second electrically insulating layer (25) is provided with at least one polycrystalline silicon, poly-Si, feedthrough (28) extending from the first device layer (20) through the second electrically insulating layer (25) to the second device layer (30) for electrically coupling a structural element of the first device layer (20) to a structural element (32) of the second device layer (30) and/or to an electrical connection provided in the cap layer (40).

3. The MEMS device according to claim 2, wherein electrically insulating material in the second electrically insulating layer (25) has been removed about the at least one poly-Si feedthrough (28) such that the at least one poly-Si feedthrough (28) is the only mechanical contact between the respective structural elements of the first device layer (20) and the second device layer (30).

4. The MEMS device according to any one of claims 1 to 3, wherein the first device layer (20) comprises at least one stopper structure (628) extending towards the second device layer (30) over a distance that is less than the thickness of the second electrically insulating layer (25).

5. The MEMS device according to any one of claims 1 to 4, further comprising a metallic bonding layer between the second device layer (30) and the cap layer (40), and the metallic bonding layer is further configured to form part of said walls of the enclosure (11).

6. A method for manufacturing a MEMS device according to any one of claims 1 to 4, the method comprising:
- forming the handle layer (10) out of a mono-Si handle wafer, the forming of the handle layer (10) comprising forming at least one cavity (11, 11') and simultaneously forming the at least one suspension structure (12) on a first face of the handle layer (10), and covering the first face of the handle layer (10) with a first electrically insulating layer (15);
- forming a second electrically insulating layer (25) on a mono-Si wafer (430);
- patterning the second electrically insulating layer (25);
- depositing a poly-Si layer (20) on top of the patterned second electrically insulating layer (25);
- forming the first device layer (20) out of the first poly-Si layer (20), the forming the first device layer (20) comprising thinning the first poly-Si layer into a first thickness and forming a plurality of first trenches (21) extending through the first device layer (20) by means of dry etching;
- fusion bonding the first device layer (20) on the first electrically insulating layer (25) on the first face of the handle layer (10);
- forming the second device layer (30) out of the mono-Si wafer (430), the forming the second device layer (30) comprising thinning the mono-Si wafer (430) into a second thickness, optionally forming at least one recessed area (330) in the second mono-Si wafer, and dry etching a plurality of second trenches extending through the second mono-Si wafer (430);
- releasing structural elements (21, 24, 31a, 31b, 32) of the first (20) and second device layer (30) by removing exposed portions of the first (15) and second electrically insulating layers (25) over thickness of the first and second electrically insulating layers by hydrofluoric acid (HF) etching; and
- enclosing structural elements within the enclosure by bonding the cap layer (40) on top of the second device layer (30).

7. The method according to claim 6, wherein
- the step of patterning the second electrically insulating layer comprises removing one or more portions (26) of the second electrically insulating layer (25) over the entire thickness of the second electrically insulating layer, and
- the step of depositing a poly-Si layer causes, by filling said removed portions (26) of the second electrically insulating layer with deposited poly-Si, generation of one or more poly-Si feedthroughs (28) extending from the first device layer (20) through the second electrically insulating layer (25) to the second device layer (30) for electrically coupling one or more structural elements of the first device layer (20) and the second device layer (30).

8. The method according to claim 6 or 7, wherein:
- the step of patterning the second electrically insulating layer (25) comprises recessing one or more portions (626) of the second electrically insulating layer over a part of thickness of the second electrically insulating layer (25), and
- the step of depositing a poly-Si layer further causes, by filling said recessed one or more portions (626) of the second electrically insulating layer (25), generating one or more poly-Si stopper structures (628) extending towards the second device layer (30).

9. The method according to any one of claims 6 to 8, further comprising:
- forming at least one recessed area (330) in the mono-Si wafer (430) after thinning the first poly-Si layer into a first thickness and before forming a plurality of first trenches extending through the first device layer (20).

10. The method according to any one of claims 6 to 9, when dependent on claim 5, further comprising:
- bonding the second device layer (30) with the cap layer (40) by a metallic bonding layer.

## Patentansprüche

1. Mikroelektromechanisches-System-Bauelement (MEMS-Bauelement) umfassend von unten nach oben:
- eine Trägerschicht (10), die mindestens einen Hohlraum und mindestens eine Aufhängungsstruktur (12) umfasst,
- eine erste elektrisch isolierende Schicht (15),
- eine erste Bauelementschicht (20), die durch Strukturierung einer Schicht von abgeschiedenem polykristallinem Silicium, poly-Si, ausgebildet ist, wobei mindestens ein Strukturelement in der ersten Bauelementschicht durch die mindestens eine Aufhängungsstruktur (12) aufgehängt ist, und das mindestens eine Strukturelement wahlweise mindestens ein seismisches Element (22) umfasst,
- eine zweite elektrisch isolierende Schicht (25),
- eine zweite Bauelementschicht (30), die mindestens ein oberhalb der ersten Bauelementschicht beweglich aufgehängtes seismisches Element (31) umfasst, wobei die zweite Bauelementschicht durch Strukturierung einer Schicht von monokristallinem Silicium, mono-Si, ausgebildet ist, und
- eine Deckschicht (40),
wobei die Trägerschicht (10), die erste Bauelementschicht (20), die zweite Bauelementschicht (30) und die Deckschicht (40), die erste elektrisch isolierende Schicht (15), die die Trägerschicht und die erste Bauelementschicht durch Bonding verbindet, und die zweite elektrisch isolierende Schicht (25), die die erste Bauelementschicht (20) und die zweite Bauelementschicht (30) durch Bonding verbindet, dazu ausgelegt sind, Wände einer Umschließung auszubilden, die das mindestens eine seismische Element (31) in der zweiten Bauelementschicht (30) und mindestens eine statische Elektrode (21) und mindestens eine bewegliche Elektrode zur Erfassung und/oder Bewirkung einer Bewegung des mindestens einen seismischen Elements (31) umfasst, wobei sich die mindestens eine statische Elektrode (21) in der ersten Bauelementschicht (20) befindet.

2. MEMS-Bauelement nach Anspruch 1, wobei die zweite elektrisch isolierende Schicht (25) mit mindestens einer Durchkontaktierung (28) aus polykristallinem Silizium, poly-Si, versehen ist, die sich von der ersten Bauelementschicht (20) durch die zweite elektrisch isolierende Schicht (25) bis zur zweiten Bauelementschicht (30) erstreckt, um ein Strukturelement der ersten Bauelementschicht (20) mit einem Strukturelement (32) der zweiten Bauelementschicht (30) und/oder mit einem in der Deckschicht (40) vorgesehenen elektrischen Anschluss elektrisch zu koppeln.

3. MEMS-Bauelement nach Anspruch 2, wobei das elektrisch isolierende Material in der zweiten elektrisch isolierenden Schicht (25) um die mindestens eine poly-Si-Durchkontaktierung (28) herum entfernt wurde, so dass die mindestens eine poly-Si-Durchkontaktierung (28) der einzige mechanische Kontakt zwischen den jeweiligen Strukturelementen der ersten Bauelementschicht (20) und der zweiten Bauelementschicht (30) ist.

4. MEMS-Bauelement nach einem der Ansprüche 1 bis 3, wobei die erste Bauelementschicht (20) mindestens eine Anschlagstruktur (628) umfasst, die sich über eine Distanz, die kleiner als die Dicke der zweiten elektrisch isolierenden Schicht (25) ist, zur zweiten Bauelementschicht (30) hin erstreckt.

5. MEMS-Bauelement nach einem der Ansprüche 1 bis 4, das ferner eine metallische Bondschicht zwischen der zweiten Bauelementschicht (30) und der Deckschicht (40) umfasst, und wobei die metallische Bondschicht ferner dazu ausgelegt ist, einen Teil der Wände der Umschließung (11) auszubilden.

6. Verfahren zur Herstellung eines MEMS-Bauelements nach einem der Ansprüche 1 bis 4, wobei das Verfahren umfasst:
- Ausbilden der Trägerschicht (10) aus einem mono-Si-Trägerwafer, wobei das Ausbilden der Trägerschicht (10) umfasst: Ausbilden mindestens eines Hohlraums (11, 11') und gleichzeitiges Ausbilden der mindestens einen Aufhängungsstruktur (12) auf einer ersten Fläche der Trägerschicht (10), und Bedecken der ersten Fläche der Trägerschicht (10) mit einer ersten elektrisch isolierenden Schicht (15);
- Ausbilden einer zweiten elektrisch isolierenden Schicht (25) auf einem mono-Si-Wafer (430);
- Strukturieren der zweiten elektrisch isolierenden Schicht (25);
- Abscheiden einer poly-Si-Schicht (20) oben auf der strukturierten zweiten elektrisch isolierenden Schicht (25);
- Ausbilden der ersten Bauelementschicht (20) aus der ersten poly-Si-Schicht (20), wobei das Ausbilden der ersten Bauelementschicht (20) umfasst: Verdünnen der ersten poly-Si-Schicht zu einer ersten Dicke und Ausbilden von mehreren sich durch die erste Bauelementschicht (20) erstreckenden ersten Gräben (21) durch Trockenätzen;
- Fusionsbonden der ersten Bauelementschicht (20) mit der ersten elektrisch isolierenden Schicht (25) auf der ersten Fläche der Trägerschicht (10);
- Ausbilden der zweiten Bauelementschicht (30) aus dem mono-Si-Wafer (430), wobei das Ausbilden der zweiten Bauelementschicht (30) umfasst: Verdünnen des mono-Si-Wafers (430) zu einer zweiten Dicke, wahlweise Ausbilden mindestens eines vertieften Bereichs (330) im zweiten mono-Si-Wafer, und Trockenätzen von mehreren sich durch den zweiten mono-Si-Wafer (430) erstreckenden zweiten Gräben;
- Freisetzen von Strukturelementen (21, 24, 31a, 31b, 32) der ersten (20) und zweiten (30) Bauelementschicht durch Entfernen freiliegender Abschnitte der ersten (15) und zweiten (25) elektrisch isolierenden Schicht über die Dicke der ersten und zweiten elektrisch isolierenden Schicht durch Ätzen mit Flusssäure (HF); und
- Umschließen von Strukturelementen innerhalb der Umschließung durch Bonden der Deckschicht (40) oben auf der zweiten Bauelementschicht (30).

7. Verfahren nach Anspruch 6, wobei
- der Schritt des Strukturierens der zweiten elektrisch isolierenden Schicht umfasst: Entfernen eines oder mehrerer Abschnitte (26) der zweiten elektrisch isolierenden Schicht (25) über die gesamte Dicke der zweiten elektrisch isolierenden Schicht, und
- der Schritt des Abscheidens einer poly-Si-Schicht, durch Füllen der entfernten Abschnitte (26) der zweiten elektrisch isolierenden Schicht mit abgeschiedenem poly-Si, die Erzeugung einer oder mehrerer poly-Si-Durchkontaktierungen (28) bewirkt, die sich von der ersten Bauelementschicht (20) durch die zweite elektrisch isolierende Schicht (25) bis zur zweiten Bauelementschicht (30) erstrecken, um ein oder mehrere Strukturelemente der ersten Bauelementschicht (20) und der zweiten Bauelementschicht (30) elektrisch zu koppeln.

8. Verfahren nach Anspruch 6 oder 7, wobei:
- der Schritt des Strukturierens der zweiten elektrisch isolierenden Schicht (25) umfasst: Vertiefen eines oder mehrerer Abschnitte (626) der zweiten elektrisch isolierenden Schicht über einen Teil der Dicke der zweiten elektrisch isolierenden Schicht (25), und
- der Schritt des Abscheidens einer poly-Si-Schicht, durch Füllen des einen oder der mehreren vertieften Abschnitte (626) der zweiten elektrisch isolierenden Schicht (25), ferner die Erzeugung einer oder mehrerer poly-Si-Anschlagstrukturen (628) bewirkt, die sich zur zweiten Bauelementschicht (30) hin erstrecken.

9. Verfahren nach einem der Ansprüche 6 bis 8, ferner umfassend:
- Ausbilden mindestens eines vertieften Bereichs (330) im mono-Si-Wafer (430) nach dem Verdünnen der ersten poly-Si-Schicht zu einer ersten Dicke und vor dem Ausbilden von mehreren sich durch die erste Bauelementschicht erstreckenden ersten Gräben.

10. Verfahren nach einem der Ansprüche 6 bis 9, wenn in Abhängigkeit von Anspruch 5, ferner umfassend:
- Bonden der zweiten Bauelementschicht (30) mit der Deckschicht (40) durch eine metallische Bondschicht.

## Revendications

1. Dispositif de système microélectromécanique (MEMS) comprenant, du bas en haut :
- une couche support (10) comprenant au moins une cavité et au moins une structure de suspension (12),
- une première couche d'isolation électrique (15),
- une première couche de dispositif (20) formée par la structuration d'une couche de silicium polycristallin, poly-Si, déposé, au moins un élément de structure dans la première couche de dispositif étant suspendu par ladite au moins une structure de suspension (12), et ledit au moins un élément de structure comprenant facultativement au moins un élément sismique (22),
- une deuxième couche d'isolation électrique (25),
- une deuxième couche de dispositif (30) comprenant au moins un élément sismique (31) suspendu de manière mobile au-dessus de la première couche de dispositif, ladite deuxième couche de dispositif étant formée par la structuration d'une couche de silicium monocristallin, mono-Si, déposé, et
- une couche de couverture (40),
dans lequel la couche support (10), la première couche de dispositif (20), la deuxième couche de dispositif (30) et la couche de couverture (40), la première couche d'isolation électrique (15) reliant la couche support et la première couche de dispositif et la deuxième couche d'isolation électrique (25) reliant la première couche de dispositif (20) et la deuxième couche de dispositif (30) sont configurées pour former des parois d'une enceinte comprenant ledit au moins un élément sismique (31) dans la deuxième couche de dispositif (30) et au moins une électrode statique (21) et au moins une électrode mobile pour détecter et/ou provoquer le mouvement dudit au moins un élément sismique (31), ladite au moins une électrode statique (21) se trouvant dans la première couche de dispositif (20).

2. Dispositif MEMS selon la revendication 1, dans lequel la deuxième couche d'isolation électrique (25) est munie d'au moins une traversée (28) de silicium polycristallin, poly-Si, s'étendant de la première couche de dispositif (20) à travers la deuxième couche d'isolation électrique (25) jusqu'à la deuxième couche de dispositif (30) afin de coupler électriquement un élément de structure de la première couche de dispositif (20) à un élément de structure (32) de la deuxième couche de dispositif (30) et/ou à une connexion électrique prévue dans la couche de couverture (40).

3. Dispositif MEMS selon la revendication 2, dans lequel le matériau isolant électrique dans la deuxième couche d'isolation électrique (25) a été éliminé autour de ladite au moins une traversée poly-Si (28) de telle sorte que ladite au moins une traversée poly-Si (28) est le seul contact mécanique entre les éléments de structure respectifs de la première couche de dispositif (20) et de la deuxième couche de dispositif (30).

4. Dispositif MEMS selon l'une des revendications 1 à 3, dans lequel la première couche de dispositif (20) comprend au moins une structure de butée (628) s'étendant vers la deuxième couche de dispositif (30) sur une distance qui est inférieure à l'épaisseur de la deuxième couche d'isolation électrique (25).

5. Dispositif MEMS selon l'une des revendications 1 à 4, comprenant également une couche de liaison métallique entre la deuxième couche de dispositif (30) et la couche de couverture (40), et dans lequel la couche de liaison métallique est également configurée pour former une partie desdites parois de l'enceinte (11).

6. Procédé de fabrication d'un dispositif MEMS selon l'une des revendications 1 à 4, le procédé comprenant les étapes consistant à :
- former une couche support (10) à partir d'une tranche support mono-Si, la formation de la couche support (10) comprenant les étapes consistant à former au moins une cavité (11, 11') et former simultanément ladite au moins une structure de suspension (12) sur une première face de la couche support (10), et recouvrir la première face de la couche support (10) d'une première couche d'isolation électrique (15);
- former une deuxième couche d'isolation électrique (25) sur une tranche mono-Si (430);
- structurer la deuxième couche d'isolation électrique (25);
- déposer une couche poly-Si (20) sur la deuxième couche d'isolation électrique structurée (25);
- former la première couche de dispositif (20) à partir de la première couche poly-Si (20), la formation de la première couche de dispositif (20) comprenant les étapes consistant à amincir la première couche poly-Si jusqu'à une première épaisseur et former par gravure à sec plusieurs premières tranchées (21) s'étendant à travers la première couche de dispositif (20);
- réaliser un bonding par fusion de la première couche de dispositif (20) avec la première couche d'isolation électrique (25) sur la première face de la couche support (10);
- former une deuxième couche de dispositif (30) à partir de la tranche mono-Si (430), la formation de la deuxième couche de dispositif (30) comprenant les étapes consistant à amincir la tranche mono-Si (430) jusqu'à une deuxième épaisseur, facultativement former au moins une zone de renfoncement (330) dans la deuxième tranche mono-Si, et graver à sec plusieurs deuxièmes tranchées s'étendant à travers la deuxième tranche mono-Si (430);
- mettre à nu des éléments de structure (21, 24, 31a, 31b, 32) des première (20) et deuxième (30) couches de dispositif par l'élimination de parties exposées des première (15) et deuxième (25) couches d'isolation électrique sur l'épaisseur des première et deuxième couches d'isolation électrique par gravure à l'acide fluorhydrique (HF); et
- enfermer des éléments de structure dans l'enceinte par bonding de la couche de couverture (40) sur la deuxième couche de dispositif (30).

7. Procédé selon la revendication 6, dans lequel
- l'étape de structurer la deuxième couche d'isolation électrique comprend l'étape consistant à éliminer une ou plusieurs parties (26) de la deuxième couche d'isolation électrique (25) sur toute l'épaisseur de la deuxième couche d'isolation électrique, et
- l'étape de déposer une couche poly-Si, en remplissant lesdites parties éliminées (26) de la deuxième couche d'isolation électrique avec du poly-Si déposé, provoque la génération d'une ou plusieurs traversées poly-Si (28) s'étendant de la première couche de dispositif (20) à travers la deuxième couche d'isolation électrique (25) jusqu'à la deuxième couche de dispositif (30) afin de coupler électriquement un ou plusieurs éléments de structure de la première couche de dispositif (20) et de la deuxième couche de dispositif (30).

8. Procédé selon la revendication 6 ou 7, dans lequel :
- l'étape de structurer la deuxième couche d'isolation électrique (25) comprend l'étape consistant à renfoncer une ou plusieurs parties (626) de la deuxième couche d'isolation électrique sur une partie de l'épaisseur de la deuxième couche d'isolation électrique (25), et
- l'étape de déposer une couche poly-Si, en remplissant lesdites une ou plusieurs parties de renfoncement (626) de la deuxième couche d'isolation électrique (25), provoque également la génération d'une ou plusieurs structures de butée poly-Si (628) s'étendant vers la deuxième couche de dispositif (30).

9. Procédé selon l'une des revendications 6 à 8, comprenant également l'étape consistant à :
- former au moins une première partie de renfoncement (330) dans la tranche mono-Si (430) après avoir aminci la première couche poly-Si jusqu'à une première épaisseur et avant de former plusieurs premières tranchées s'étendant à travers la première couche de dispositif.

10. Procédé selon l'une des revendications 6 à 9, quand il dépend de la revendication 5, comprenant également l'étape consistant à :
- relier la deuxième couche de dispositif (30) à la couche de couverture (40) par une couche de liaison métallique.
